# EUROPÄISCHE PATENTSCHRIFT

(11) **EP 3 701 599 B1**
(45) Veröffentlichungstag und Bekanntmachung des Hinweises auf die Patenterteilung: **18.08.2021**
(21) Anmeldenummer: 18804238.6
(22) Anmeldetag: 29.10.2018
(51) Int. Cl.: H01R 31/02, H01R 29/00, H01R 107/00

(54) **STROMANSCHLUSSVERTEILER**
POWER CONNECTION DISTRIBUTOR
DISTRIBUTEUR DE BRANCHEMENTS ÉLECTRIQUES

(30) Priorität: 20.12.2017 DE 202017107765 U
(43) Veröffentlichungstag der Anmeldung: 02.09.2020
(73) Patentinhaber: Vertiv Integrated Systems GmbH, 94424 Arnstorf (DE)
(72) Erfinder: FEIGL, Josef, 94424 Arnstorf (DE); HARANT, Petr, 340 21 Loucany (CZ); HUBER, Arthur, 94081 Fürstenzell (DE)
(74) Vertreter: Wunderlich & Heim Patentanwälte Partnerschaftsgesellschaft mbB
(86) Internationale Anmeldenummer: PCT/EP2018/079553
(87) Internationale Veröffentlichungsnummer: WO 2019/120712

(56) Entgegenhaltungen:
- US-A1- 2008 309 160

## Beschreibung

Die vorliegende Erfindung betrifft einen Stromanschlussverteiler für elektrische Energie gemäß Oberbegriff des Anspruch 1 sowie einen Serverschrank mit einem Stromanschlussverteiler gemäß Anspruch 8.

Bei einem gattungsgemäßen Stromanschlussverteiler ist mindestens ein Verbraucheranschluss für mindestens einen Verbraucher, zum Versorgen des Verbrauchers mit elektrischer Energie, mindestens ein Verbindungselement zu einer Gebäudeenergieversorgung, insbesondere zu mindestens einem Starkstromanschluss, welches den mindestens einen Verbraucher mit der Gebäudeenergieversorgung verbindet, mindestens ein Leitungselement, welches zwischen dem Verbindungselement und dem mindestens einen Verbraucheranschluss vorgesehen ist, und ein Verbinder vorgesehen, welcher zwischen Verbraucheranschluss und Verbindungselement angeordnet ist, wobei das Verbindungselement verbraucherseitig mindestens zwei Leiter zur Energieversorgung aufweist, die mit dem mindestens einen Verbraucher stromleitend in Verbindung stehen. Hierbei steht der Verbinder energieversorgungsseitig mit dem mindestens einen Leitungselement in Verbindung, welches jeweils mit mindestens zwei Leitern zur Energieversorgung ausgebildet ist, die an die Gebäudeenergieversorgung anschließbar sind. Auch ist in Abhängigkeit von der ist-Spannung und/oder dem Stromsystem der Gebäudeenergieversorgung das mit der Gebäudeenergieversorgung zu verbindende Leitungselement austauschbar und zwischen dem Verbinder und jedem der austauschbaren Leitungselement besteht eine standardisierte lösbare Steckverbindung.

Aufgrund der bestehenden Unterschiede in den weltweit eingesetzten Stromversorgungssystemen besteht das andauernde Bedürfnis eine Kompatibilität zwischen einem Verbraucher und jeweiligen Energieversorgungssystem bereitzustellen. Eine der Hürden, welche hierbei zu nehmen sind, betrifft die unterschiedliche Spannungsversorgung der einzelnen Stromsysteme. Beispielsweise besteht in Europa weitestgehend ein Stromverteilungsnetzwerk, welches mit 230 V betrieben wird. Im Gegensatz hierzu ist beispielsweise in Nordamerika ein Betrieb von Verbrauchern mit 110 V üblich. Ein solcher Verbraucher kann beispielsweise ein Serverschrank sein, in welchem einzelne Servermodule vorgesehen sind, welche mit einer einheitlichen Spannung betreibbar sind. Neben unterschiedlichen Spannungen sind auch die vorhandenen Leitungen, das heißt beispielsweise die Phasen sowie der Nullleiter, gegeneinander, abhängig vom Stromverteilungsnetzwerk unterschiedlich verschaltet.

Je nachdem für welchen Kontinent der Verbraucher, beziehungsweise der Serverschrank mit den Servermodulen, bestimmt ist, ist nach dem bisherigen Stand der Technik ein Stromwandler vorzusehen, welcher die Spannung einer Gebäudeenergieversorgung auf das Betriebsniveau der Verbraucher reguliert beziehungsweise Verbraucher, die an das ortsübliche Spannungsniveau und die Verkabelungsart angepasst sind.

Zwar ist es grundsätzlich möglich, beispielsweise mittels Transformatoren, eine Versorgungsspannung an die Betriebsspannung eines Verbrauchers anzupassen. Dies ist jedoch mit Kosten sowie einem erhöhten Fertigungsaufwand verbunden.

Ein Stromanschlussverteiler für elektrische Energie ist aus der US 2008/309160 A1 bekannt. Dieser Stromanschlussverteiler ist über ein Verbindungselement als Zuführkabel einerseits mit einer Gebäudeenergieversorgung verbunden und andererseits sind zwei Leitungselement zur Zuführung von Energie an einem Verbinder beziehungsweise einem Energie-Zuführmodul vorgesehen. Der Verbinder hat hierbei die Aufgabe, die über die Leitungselemente erhaltene Energie derart umzuwandeln, dass sie an seinen Ausgängen für Energiewandler-Module des Stromanschlussverteilers genutzt werden können. Die vom Verbinder gelieferte Energie wird in nachgeschalteten Energiewandler-Modulen in Energie umgewandelt, die von den Verbrauchern verwendet werden kann.

Zur Anpassung der ist-Spannung einer Gebäudeenergieversorgung oder eines entsprechenden Stromsystems an die Betriebsspannung eines Verbrauchers ist bei diesem bekannten Stromanschlussverteilter vorgesehen, dass man das oder die Energie-Zuführmodule gegebenenfalls zusammen mit den Energiewandler-Modulen als Baugruppen austauscht, um eine entsprechende Anpassung der Betriebsspannung eines Verbrauchers an die bestehende ist-Spannung einer Gebäudeenergieversorgung durchzuführen.

Aus der WO 2013/127121 A1 ist ein gattungsgemäßer Stromanschlussverteiler als Steckdosenleiste bekannt, bei dem die verwendeten Stecker variiert werden können, wobei dieser Stromanschlussverteiler einphasig ausgelegt ist.

Die vorliegende Erfindung stellt sich die Aufgabe einen Stromanschlussverteiler sowie einen Serverschrank mit Stromanschlussverteiler bereitzustellen, welche mit einfachen Mitteln bedarfsgerecht die bestehende ist-Spannung einer Gebäudeenergieversorgung und/oder eines bestehenden Stromsystems an die Betriebsspannung eines Stromanschlussverteilers beziehungsweise eines Verbrauchers anpasst.

Die Aufgabe wird gemäß der vorliegenden Erfindung durch einen Stromanschlussverteiler mit den Merkmalen des Anspruchs 1 sowie einen Serverschrank mit den Merkmalen des Anspruchs 8 gelöst.

Ein solcher Stromanschlussverteilter ist erfindungsgemäß dadurch gekennzeichnet, dass das Verbindungselement für eine zwei- oder dreiphasige Gebäudeenergieversorgung ausgebildet ist sowie das Leitungselement zum Anschluss an zwei oder drei Phasen ausgelegt ist und dass der Verbinder mit jeweils mindestens einer elektrischen Sicherung für jede Leitung zur Gebäudeenergieversorgung ausgebildet ist.

Ein erster Grundgedanke der vorliegenden Erfindung besteht darin, insbesondere durch entsprechende Verkabelung eine Anpassung der Spannung und/oder des Versorgungssystems einer Gebäudeenergieversorgung an die Betriebsspannung und/oder des Stromsystems eines Verbrauchers vorzunehmen. Dies kann insbesondere durch entsprechende Verkabelung beziehungsweise Verschaltung zwischen der Gebäudeenergieversorgung und dem Verbraucher bewirkt werden. Vorzugsweise kann hierbei auf die Verwendung von Transformatoren für den erfindungsgemäßen Zweck der Spannungsanpassung verzichtet werden, da die Anpassung der Spannung des bestehenden Stromsystems an eine Betriebsspannung des Verbrauchers bereits durch entsprechendes verbinden von Leitern der Gebäude Energieversorgung mit Leitern des Verbrauchers erreichbar ist.

Soll der Verbraucher über ein Stromsystem beziehungsweise mit einer ist-Spannung betrieben werden, welche seiner Betriebsspannung entspricht, kann durch Austausch des Leitungselements und/oder des Verbinders eine Weiterleitung der Energie ohne Anpassung der Spannung erreicht werden, ohne dass der gesamte Stromanschlussverteiler ausgetauscht werden müsste.

Mit Gebäudeenergieversorgung ist erfindungsgemäß jede elektrische Energiequelle zu verstehen, mittels welcher der erfindungsgemäße Stromanschlussverteiler mit elektrischer Energie betreibbar ist. Die Gebäudeenergieversorgung kann insbesondere eine öffentliche Stromversorgung, bevorzugt eine Starkstromversorgung, eine Solaranlage, eine Windkraftanlage und/oder ein Aggregat mit Brennstoff aufweisen. Diese Aufzählung soll insbesondere verdeutlichen, dass die Gebäudeenergieversorgung nicht durch ihre Art der Energieerzeugung oder Bereitstellung beschränkt ist.

Vorzugsweise können für eine Anpassung der ist-Spannung an eine Betriebsspannung des Verbrauchers mindestens 2 Phasen der Gebäudeenergieversorgung mit dem Null-Leiter bzw. der Phase des Verbrauchers verbunden.

Nach der vorliegenden Erfindung ist es vorgesehen, dass der Verbinder mit jeweils mindestens einer Sicherung für jede Leitung zur Energieversorgung ausgebildet ist. Zwar benötigt grundsätzlich ein verbraucherseitig vorgesehener Null-Leiter keine zusätzliche Sicherung. Da diese jedoch bei einer Anpassung an ein Stromsystem mit zwei Phasen verbunden werden kann, kann es zweckdienlich sein, die beiden Leiter, welche vom Verteiler zu dem mindestens einen Verbraucheranschluss führen einzelnen abzusichern. Nach einer bevorzugten Weiterbildung der vorliegenden Erfindung ist es vorgesehen, dass der Verbinder mit mehreren Anschlüssen für Leitungselemente ausgebildet ist, wobei eine zur Verfügung gestellte Energie für den mindestens einen Verbraucher und/oder eine Anzahl an aktiven Verbraucheranschlüssen anpassbar ist. Mit jeder Verbindung zwischen Verbinder und Gebäudeenergieversorgung wird für den Stromanschlussverteiler zusätzliche Energie bereitgestellt. So kann beispielsweise durch Verbinden von Verbinder und Gebäudeenergieversorgung mittels zwei Leitungselementen die doppelte Energie für den mindestens einen Verbraucher an dem Verbraucheranschluss bereitgestellt werden. Ebenfalls können durch mehrere Leitungselemente zwischen Verbinder und Gebäudeenergieversorgung zusätzliche Verbraucher mit Energie versorgt werden, also die Anzahl an Verbraucheranschlüssen erhöht werden. Gemäß der Erfindung ist vorgesehen, dass zwischen dem Verbinder und jedem der austauschbaren Leitungselemente eine einheitliche, lösbare Steckverbindung besteht.

Die voranstehend beschriebene alternative Verdrahtung von Null-Leiter und Phase des Verbrauchers mit zwei Phasen der Gebäudeenergieversorgung, welche letztlich bei unterschiedlichen Energiesystemen zwischen Gebäudeenergieversorgung und Verbraucher zu einer adäquaten Spannungsversorgung für den Verbraucher führt, kann bereits in dem Leitungselement vorgesehen sein. Durch Lösen der Steckverbindung zu dem Verbinder kann das Leitungselement austauschbar vorgesehen sein. Hierdurch ist eine bedarfsgerechte Anpassung des Leitungselements an die bestehende ist-Spannung der Gebäudeenergieversorgung beziehungsweise eine Anpassung der ist-Spannung an die Verbraucherspannung ermöglicht.

Durch die vorzugsweise einheitliche Ausbildung der Steckverbindung zwischen Verbinder und Leitungselement sind keine speziellen Kenntnisse über die jeweiligen Eigenheiten des bestehenden Stromsystems erforderlich. Durch eine einfache Kennzeichnung der einzelnen austauschbaren Leitungselemente, beispielsweise mit einer Länderkennung oder einem Hinweis auf die ist-Spannung beziehungsweise seine Eignung für ein bestimmtes Stromsystem, ist jeder Benutzer in die Lage versetzt, eine Anpassung des Stromanschlussverteilers an die jeweilige Gebäudeenergieversorgung vorzunehmen.

Vorzugsweise weist die Steckverbindung zwischen Leitungselement und Verbinder eine Form und/oder Geometrie auf, welche lediglich eine Art der Verbindung zwischen den beiden Teilen ermöglicht. Hierbei kann die Steckverbindung beispielsweise mit einer Anzahl an Steckverbindungselementen ausgebildet sein, welche beispielsweise jeweils mit einer Leitung der Gebäudeenergieversorgung verbunden ist. Durch entsprechende Anordnung und/oder Verdrahtung der Steckverbindungselemente in der Steckverbindung kann hierdurch in vordefinierte Weise beispielsweise eine Phase der Gebäudeenergieversorgung mit einer Phase des Verbrauchers oder jedoch mit einem Null-Leiter des Verbrauchers verbunden werden. So kann beispielsweise mittels eines ersten Leitungssegments eine Phase der Gebäudeenergieversorgung mit einer Leitung verbunden werden, welche zu einem angeschlossenen Verbraucher führt und mittels eines zweiten Leitungssegments ein Null-Leiter der Gebäudeenergieversorgung mit einer zweiten Leitung verbunden werden, welche zu demselben angeschlossenen Verbraucher führt.

Hierdurch wäre beispielsweise eine für Europa übliche Stromversorgung bereitgestellt, bei welcher der Verbraucher mit einer Phase und dem Nullleiter verbunden wird.

Durch den sprechenden Austausch des Leitungselements können beispielsweise zwei Leitungen für die Energieversorgung mindestens eines Verbrauchers mit insgesamt zwei Phasen der Gebäudeenergieversorgung verbunden werden, also jeweils ein Leiter mit einer Phase. Da die Spannung einer Phase gegenüber einer vorgesehenen potentiellen Erde periodisch zwischen einem Maximum und einem Minimum, insbesondere einem negativen Minimum, schwankt, wobei die Periodizität der einzelnen Phasen gegeneinander versetzt ist, lässt sich durch das Verbinden eines Verbrauchers mit zwei Phasen der Gebäudeenergieversorgung verbraucherseitig eine Spannung bereitstellen, welche größer ist als die maximale ist-Spannung einer Phase gegenüber der potentiellen Erde.

Besonders zweckmäßig ist es nach einer Weiterbildung der Erfindung, dass der Verbinder mit mehreren Verbraucheranschlusssegmenten verbindbar ist, wobei eine Energie für den mindestens einen Verbraucher und/oder eine Anzahl von aktiven Verbraucheranschlüssen anpassbar ist. Grundsätzlich können aktive Verbraucheranschlüsse solche sein, welche über den Verbinder und das Leitungselement mit der Gebäudeenergieversorgung verbunden sind. Jedes Verbraucheranschlusssegment kann mit mindestens einem Verbraucheranschluss gebildet sein, wobei das Verbraucheranschlusssegment vorzugsweise lösbar mit dem Verbinder verbindbar ist. Somit kann der Verbinder Anschlüsse für Leitungselemente und/oder Anschlüsse für Verbraucheranschlusssegment aufweisen. Hierdurch kann die Anzahl an Verbraucheranschlüssen und Leitungselementen bedarfsgerecht anpassbar sein.

Nach einer besonderen Weiterbildung der vorliegenden Erfindung ist es vorgesehen, dass über dieselbe Steckverbindung mehr als ein Leitungselement mit dem Verbinder verbindbar ist. Grundsätzlich ist es denkbar zwei oder mehr Leitungselemente miteinander in einer Steckverbindung bzw. einem Anschluss an dem Verbinder zu kombinieren. Hierdurch kann beispielsweise eine höhere, vorzugsweise bei zwei verbundenen Leitungen doppelte Energie, für den Stromanschlussverteiler bereitgestellt werden, wobei lediglich ein Anschluss an dem Verteiler belegt wird.

Besonders bevorzugt ist es nach einer Weiterbildung der Erfindung, dass die mindestens eine Steckverbindung eine Verdrahtung aufweist, welche zumindest einen ersten Verbraucheranschluss mit Energie versorgt oder eine Verdrahtung aufweist, welche zusätzlich mindestens einen zweiten Verbrauchanschluss mit Energie versorgt. Grundsätzlich kann eine Aufteilung der durch die Gebäudeenergieversorgung bereitgestellten Phasen auf eine Mehrzahl von Verbraucheranschlüssen in dem Verbinder bereitgestellt werden. So kann beispielsweise mittels einer beziehungsweise zwei Phasen eine beliebige Anzahl von Verbraucheranschlüssen beziehungsweise an die Verbraucheranschlüsse angeschlossene Verbraucher mit Energie versorgt werden. Beispielsweise über eine Anzahl von Steckverbindungssegmenten kann eine Aufteilung beziehungsweise Verteilung der einzelnen Phasen der Gebäudeenergieversorgung auf eine Mehrzahl von Verbraucheranschlüssen bereits in dem Leitungselement erfolgen. Beispielsweise können so mittels einer ersten Phase bzw. eines ersten Phasenpaars Verbraucheranschlüsse 1 bis 10 mit Energie versorgt werden, wobei mittels einer zweiten Phase bzw. eines zweiten Phasenpaars die Verbraucheranschlüsse 11 bis 20 des Stromanschlussverteilers mit Energie versorgt werden.

Das Leitungselement und/oder der Verbinder können eine Verdrahtung aufweisen, welche eine Phase oder ein Phasenpaar einer bestimmten Anzahl von Verbraucheranschlüssen zuweist beziehungsweise mit diesen verbindet, um diese mit Energie zu versorgen. Soll der Verbraucher mit möglichst viel Energie versorgt werden, kann es zweckdienlich sein eine Phase oder ein Phasenpaar lediglich für einen oder eine geringe Anzahl von Verbrauchern bereitzustellen. Ist es hingegen bevorzugt eine möglichst hohe Anzahl an Verbrauchern mit Energie zu versorgen, können das Leitungselement und/oder der Verbinder jeweils eine Phase oder ein Phasenpaar mit einer Mehrzahl an Verbrauchern bzw. Verbraucheranschlüssen verbinden.

Grundsätzlich kann der Verbinder so verdrahtet sein, dass eine Mehrzahl an Verbrauchern bzw. Verbraucheranschlüssen mit Energie von der Gebäudeenergieversorgung versorgt werden kann. Durch Verwendung eines Leitungselements, bei welchem beispielsweise nur eine begrenzte Anzahl der bereitgestellten Steckverbindungssegmente tatsächlich mit einer Verdrahtung belegt sind, kann die tatsächliche Anzahl an mit Energie versorgten Verbraucheranschlüssen angepasst oder reduziert werden. Bei dem zumindest einen ersten Verbraucheranschluss beziehungsweise dem zusätzlichen mindestens zweiten Verbraucheranschluss kann es sich folglich auch um eine ersten beziehungsweise eine zweite Gruppe von Verbraucheranschlüssen handeln.

Besonders bevorzugt ist es nach einer Weiterbildung der Erfindung, dass der Verbinder mit dem Leitungselement integral ausgebildet ist. Bei einem Wechsel des Energieversorgungssystems, welches insbesondere mit einem Wechsel der Versorgungsspannung einhergehen kann, kann demnach der Verbinder gemeinsam mit dem Leitungselement austauschbar vorgesehen sein. Hierdurch kann insbesondere auch eine Anzahl an vorgesehenen Sicherungen für die einzelnen Leitungen beziehungsweise ein erforderlicher Sicherungstyp bedarfsgerecht an das jeweilige Stromsystem anpassbar sein. Vorzugsweise kann eine lösbare Verbindung zwischen einem Verbraucheranschlusssegment, welches mindestens einen Verbraucheranschluss aufweist und dem Verbinder vorgesehen sein.

Nach einer zweckmäßigen Weiterbildung der vorliegenden Erfindung ist es vorgesehen, dass der Verbinder integral mit dem mindestens einen Verbraucheranschluss ausgebildet ist. Demnach wäre ein Stromanschlussverteiler vorgesehen, welche vorzugsweise lediglich mit mindestens einer lösbaren Verbindung zwischen Verbinder und Leitungselement ausgebildet ist. Hierbei kann die Aufteilung der einzelnen Phasen oder Phasenpaare auf die einzelnen Verbraucheranschlüsse des Stromanschlussverteilers wiederum in dem Leitungselement und/oder dem Verbinder erfolgen, wobei in vorangehend beschriebener Weise die Steckverbindungssegmente zwischen Leitungselement und Verbinder zusammenwirken.

Gemäß den voranstehenden Ausführungen ist die vorliegende Erfindung insbesondere darauf gerichtet, einen Stromanschlussverteiler bereitzustellen, welche lediglich durch Austausch eines Leitungselements, beispielsweise eines Verbindungskabels, zwischen Gebäudeenergieversorgung und Verbinder, eine ist-Spannung eines bestehenden Stromsystems der Gebäudeenergieversorgung an eine soll-Spannung für den Verbraucher anpasst. Bei der ist-Spannung und der soll-Spannung handelt es sich insbesondere um standardisierte Stromversorgungssysteme bzw. Energieversorgungssysteme wie sie insbesondere national bzw. regional normiert sind.

Der erfindungsgemäße Serverschrank ist dadurch gekennzeichnet, dass er mit einem erfindungsgemäßen Stromanschlussverteiler, insbesondere nach den Ansprüchen 1 bis 8 ausgebildet ist. Der Serverschrank kann hierbei mit einzelnen Servermodulen ausgebildet sein, welche für eine ordnungsgemäße Funktion eine standardisierte Stromversorgung benötigen. Diese kann beispielsweise 230 V betragen. Durch das Vorsehen des erfindungsgemäßen Stromanschlussverteilers in dem Serverschrank kann beispielsweise durch einfaches Austauschen eines Leitungselements, insbesondere eines Kabels, welches mit der Gebäudeenergieversorgung verbunden wird, eine in etwa gleichbleibende Spannung für die Verbraucher in dem Serverschrank unabhängig davon bereitgestellt werden, ob es sich beispielsweise um eine Gebäudeenergieversorgung mit 110 V oder 230 V handelt.

Üblicherweise ist ein Serverschrank mit sogenannten 19 Zoll Bereichen ausgebildet, in welchem die einzelnen Servermodule, also die Verbraucher des Serverschranks vorgesehen werden können. Der 19 Zoll Bereich ist üblicherweise innerhalb des Serverschranks vorgesehen. Zwischen mindestens einer Wand des Server Schranks und dem 19 Zollbereich kann ein Zwischenraum vorgesehen sein, in welchem die Verbraucheranschlüsse für die einzelnen Servermodule angeordnet sein können. Vorzugsweise handelt es sich hierbei um eine sogenannte Steckerleiste, welche mit einer Mehrzahl an Stromanschlüssen, also Verbraucheranschlüssen für die einzelnen Servermodule ausgebildet ist.

Der Verbinder, welcher die Verbraucheranschlüsse mit der Gebäudeenergieversorgung verbindet kann sowohl im 19 Zoll Bereich als auch außerhalb des 19 Zoll Bereichs vorgesehen sein. Wird der Verteiler im 19 Zollbereich vorgesehen, belegt dieser zumindest eine sogenannte Höheneinheit, nach welcher sich der Höhenbedarf der einzelnen Servermodule im 19 Zoll Bereich bemisst. Durch das Vorsehen des Verteilers außerhalb des 19 Zollbereich kann zusätzlicher Platz in dem Serverschrank für weitere Servermodule bereitgestellt sein.

Durch den erfindungsgemäßen Stromanschlussverteiler beziehungsweise den erfindungsgemäßen Serverschrank kann so unabhängig von einer länderspezifischen Energieversorgung eine Vormontage des Serverschanks mit seinen Modulen erfolgen, wobei lediglich das jeweils geeignete Leitungselement für das entsprechende Stromsystem zum Anschluss beigelegt werden kann. Diese kann letztlich die benötigte Energie geeigneter Spannung bereitstellen.

Die vorliegende Erfindung wird nachfolgend anhand der bereitgestellten Figuren weiter erläutert. In den Zeichnungen zeigen:
- Fig. 1: eine erste und zweite Verkabelungsvariante des erfindungsgemäßen Leitungselements,
- Fig. 2: eine dritte und vierte Verkabelungsvariante des erfindungsgemäßen Leitungselements,
- Fig. 3: eine Front- und Rückansicht einer Ausführungsform des erfindungsgemäßen Verteilers
- Fig. 4: eine perspektivische Ansicht einer Ausführungsform des erfindungsgemäßen Verteilers,
- Fig. 5: eine Seitenansicht sowie eine Draufsicht auf eine Ausführungsform einer Gruppe von erfindungsgemäßen Verbraucheranschlüssen,
- Fig. 6: eine vergrößerte Darstellung eines Ausschnitts der Draufsicht auf eine Gruppe von erfindungsgemäßen Verbraucheranschlüssen gemäß Fig. 5,
- Fig. 7: eine perspektivische Seitenansicht einer Ausführungsform des erfindungsgemäßen Serverschranks mit eingebautem Verteiler, eingebauten Verbraucheranschlüssen sowie einer Steckverbindung eines erfindungsgemäßen Leitungselements für eine Verbindung zwischen Verteiler und Verbraucheranschlüssen sowie eine Steckverbindung zwischen Verteiler und Gebäudeenergieversorgung,
- Fig. 8: eine perspektivische Darstellung eines oberen Bereichs des erfindungsgemäßen Serverschranks.

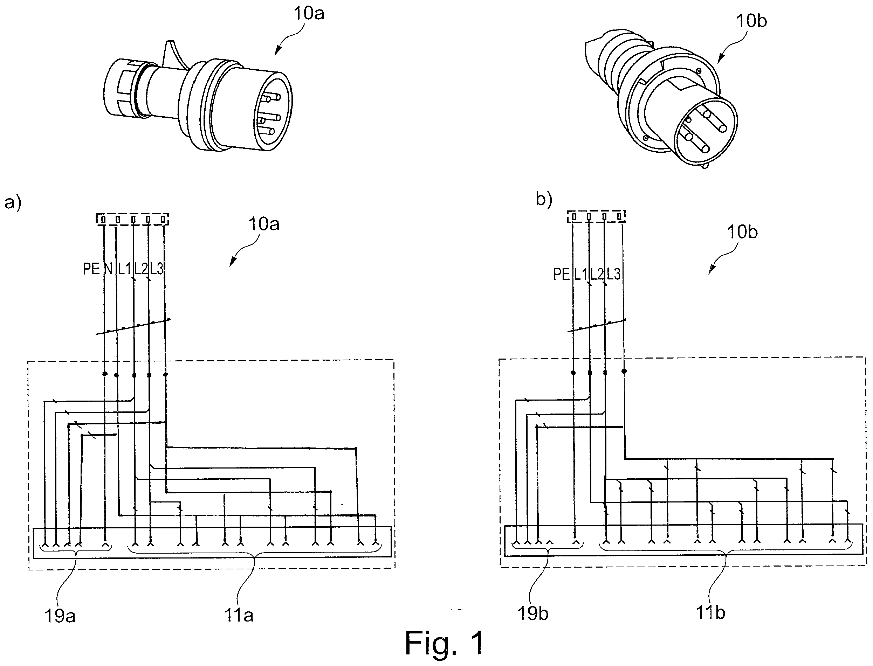

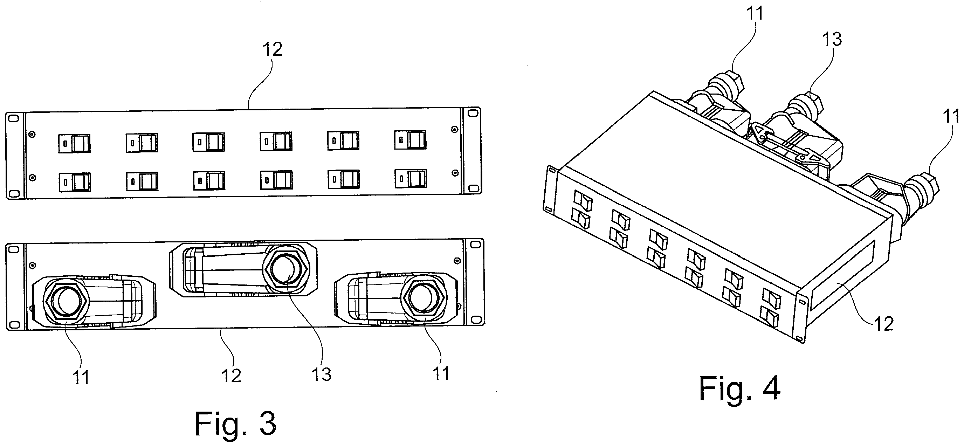

Fig. 1 zeigt zwei jeweils 3 phasige Ausführungsformen a) und b) des erfindungsgemäßen Leitungselements mit zugehörigen Schaltbildern. Die linke Variante weist einen PE-Leiter, 3 Phasen und einen Nullleiter auf, wie sie beispielsweise in Europa bei einem Starkstromanschluss Verwendung findet. Entsprechend ist der Stecker für das linke Leitungselement 10a mit 5 Kontakten ausgebildet. Die rechte Ausführungsform weist einen PE-Leiter und 3 Phasen auf, wie sie beispielsweise bei einem Starkstromanschluss in Nordamerika Verwendung findet. Entsprechend ist der Stecker für das rechte Leitungselement 10b mit 4 Kontakten ausgebildet. Ein Kabelanteil der beiden Ausführungsformen 10a und 10b des erfindungsgemäßen Leitungselements ist aus Gründen der Übersichtlichkeit nicht dargestellt. Diese sind an einem gegenüberliegenden Ende der 4 beziehungsweise 5 Kontakte vorzusehen und führen zu einem Verbinder wie er beispielsweise in Fig. 3 und 4 dargestellt ist.

Unterhalb der jeweiligen Ausführungsform ist ein Schaltbild dargestellt, welches eine mögliche Verkabelung innerhalb des Leitungselements 10 darstellt. In einem oberen Bereich ist die Anzahl an Kontakten dargestellt (4 beziehungsweise 5 Kontakte), welche der jeweilige Stecker aufweist. Diese sind im Falle des ersten Ausführungsbeispiels (10a) von links nach rechts mit "PE", "N", "L1", "L2" und "L3" bezeichnet. Grundsätzlich steht PE für den PE-Leiter, N für Null-Leiter und L1 bis L3 für die einzelnen Phasen wie sie mit der Gebäudeenergieversorgung verbunden wird.

Im Fall des zweiten Ausführungsbeispiels (10b) sind die mit den Kontakten verbundenen Leiter von links nach rechts mit "PE", "L1", "L2" und "L3" bezeichnet. Die Bezeichnung der einzelnen Leiter ist erfindungsgemäß in den Ausführungsbeispielen übergreifend einheitlich.

Das untere Ende des jeweiligen Schaltbilds stellt die Verkabelung eines verbinderseitigen Steckers 11 dar, welcher mit einem Verbinder 12 verbindbar ist. Wie aus den einzelnen Schaltbildern hervorgeht, kann die Verkabelung verbinderseitig in zwei Gruppen 11 und 19 aufgeteilt werden. Die Leitergruppen von jeweils zwei Leitern, welche der Gruppe 11 angehören, verbinden jeweils Verbraucher mit der Gebäudeenergieversorgung. Die Leiter, welche der Gruppe 19 angehören weisen die potentielle Erde beziehungsweise einer Energieversorgung für den Verteiler auf. Grundsätzlich kann der PE-Leiter auch bis zu den jeweiligen Verbrauchern geführt werden. In einem solchen Fall würde PE der Gruppe 11 angehören. Die Energieversorgung für den Verteiler ist optional vorhersehbar und kann beispielsweise für eine elektronische Steuerung bereitgestellt sein, mittels welcher eine Energiezufuhr zu einzelnen Verbraucheranschlüssen oder zu Gruppen von Verbraucheranschlüssen aktivierbar beziehungsweise deaktivierbar ist.

Wie aus einem direkten Vergleich der Schaltbilder a) und b) hervorgeht, weist das Leitungselement, wie es beispielsweise in Europa verwendet wird gemäß Ausführungsform a) für jeden Verbraucher eine Verbindung zu dem Nullleiter und zu einer Phase der Gebäudeenergieversorgung auf. Die 4-polige Ausführungsform gemäß Ausführungsform b) verbindet jeden Verbraucher mit 2 Phasen der Gebäudeenergieversorgung. Wird nunmehr die Ausführungsform a) mit 230 V betrieben und die Ausführungsform b) mit 110 V betrieben, wird verbraucherseitig in etwa dieselbe Spannung bereitgestellt. Die geringfügigen Differenzen in der bereitgestellten Spannung zwischen den beiden genannten Beispielen sind, insbesondere beim Betrieb eines Serverschranks mittels des erfindungsgemäßen Stromanschlussverteilers, vernachlässigbar.

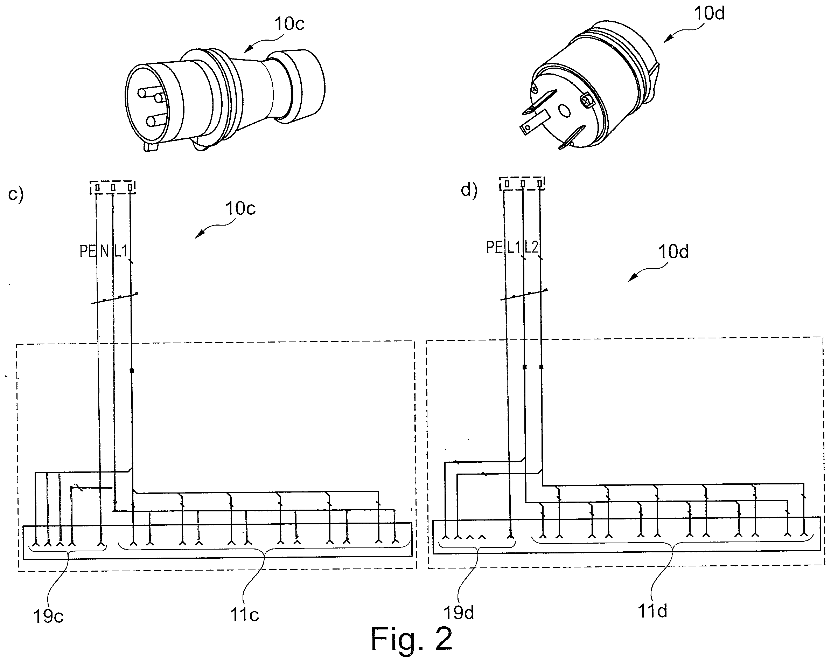

Gemäß Fig. 2 sind zwei weitere Ausführungsbeispiele c) und d) dargestellt, welche jeweils eine 3-polige Ausführungsform des Leitungselements 10 darstellen. Gemäß Fig. 2 sind wiederum jeweils lediglich der Stecker für das entsprechende System aus Gründen der Übersichtlichkeit dargestellt, wohingegen das energieleidende Kabel nicht dargestellt ist. Verbinderseitig ist nach den Ausführungsformen c) und d) vorzugsweise dieselbe Steckverbindung 11 des Leitungselements 10 zu dem Verbinder 12 vorgesehen, wie sie mit Bezug zu Fig. 1 bereits beschrieben wurde.

Die Ausführungsform c) weist wiederum eine Verbindung zu dem PE-Leiter, dem Nullleiter sowie eine Phase der Gebäudeenergieversorgung auf. Somit kann diese Ausführungsform vorzugsweise mit einer 240 V Gebäudeenergieversorgung verbunden werden. Gemäß Ausführungsform c) wird eine Phase in dem Leitungselement so aufgeteilt, dass mehrere Anschlüsse 11c für Verbraucher durch die Phase mit Energie versorgt werden. Jeder Anschluss für einen Verbraucher weist einen Kontakt zu dem Null-Leiter der Energiegebäudeversorgung und der einen Phase auf. Zusätzlich kann wiederum eine Stromversorgung 19c für den Verteiler 12 bereitgestellt werden. Dies kann demselben Zweck dienen, wie mit Bezug zu Fig. 1 bereits beschrieben wurde.

Die Ausführungsform d) gemäß Fig. 2 weist eine Verbindung zu dem PE-Leiter und zu zwei Phasen L1 und L2 der Gebäudeenergieversorgung auf. Durch eine entsprechende Verkabelung werden die beiden Phasen so aufgeteilt, dass diese jeweils mit einer Mehrzahl von Verbrauchern, gemäß Ausführungsbeispiel d) mit sechs, verbindbar ist. Ebenfalls ist gemäß Ausführungsbeispiel d) eine Energieversorgung 19d für den Verteiler 12 vorgesehen, welcher für dieselbe Funktion bereitgestellt werden kann, wie sie bereits mit Bezug zu Figur 1 beschrieben wurde. Grundsätzlich wird die Energieversorgung für den Verteiler nicht benötigt, beispielsweise wenn auf eine elektronische Schaltung zum Aktivieren von Verbraucheranschlüssen verzichtet wird.

Die Steckverbindung zwischen dem Stecker 11 und dem Verbinder 12 ist vorzugsweise normiert ausgebildet unabhängig davon, welches Leitungselement 10a bis 10d an den Verbinder 12 angeschlossen wird. Die normierte Steckverbindung zwischen dem Stecker 11 und dem Verbinder 12 ist auch dann ermöglicht, wenn eine andere vorangehend nicht beschriebene Gebäudeenergieversorgung mit dem erfindungsgemäßen Stromanschlussverteiler verbunden wird.

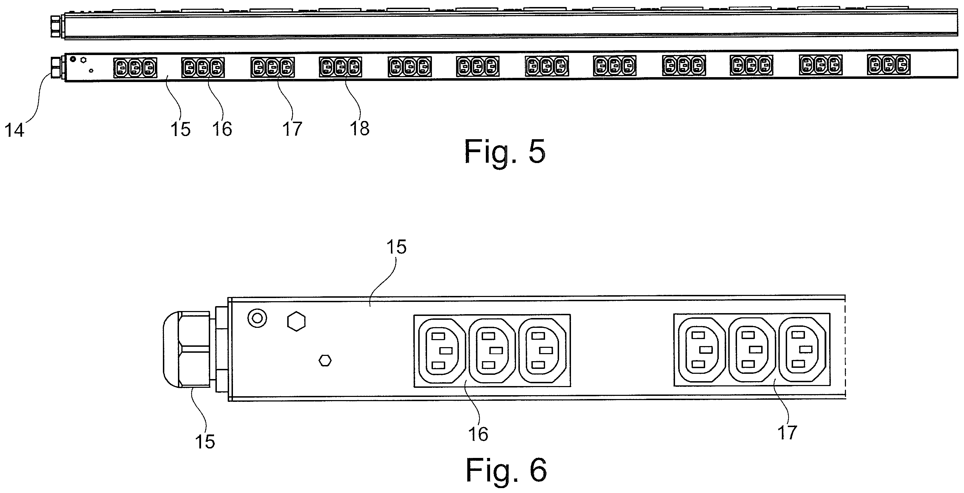

Erfindungsgemäß ist der Stromanschlussverteiler insbesondere eine Kombination aus mindestens einem Leitungselement einem Verbinder sowie mindestens einem Verbraucheranschluss, wie er bezüglich der Figuren 5 beziehungsweise 6 beschrieben wird.

Fig. 3 zeigt eine Front- beziehungsweise Rückansicht gemäß eines bevorzugten Ausführungsbeispiels eines Verteilers 12. Dieser weist im vorliegenden Fall zwei Anschlüsse für Leitungselemente 10 auf, in welchen gemäß Fig. 3 bereits ein Stecker 11 des Leitungselements 10 eingesteckt ist. Die mit dem Verbinder 12 in Verbindung stehenden Stecker 11 sind in Fig. 4 ebenfalls dargestellt. Die freien Enden der Stecker 11 in Fig. 3 und Fig. 4 weisen erfindungsgemäß Leiter, insbesondere mindestens ein Kabel auf, welche den jeweiligen Stecker 11 mit dem Stromstecker gemäß der Figuren 1 und 2 verbindet. Stecker 11, Kabel und Stromstecker können das Leitungselement bilden.

Zwischen dem jeweiligen Stecker 11 und dem Anschluss am Verteiler 12 für den Stecker 11 besteht vorzugsweise eine mehrpolige Verbindung aus männlichen Steckersegmenten und weiblichen Öffnungen für die Segmente. Die einzelnen Steckersegmente können jeweils einzelne Leitungssegmente aufweisen, wie sie beispielsweise in den Figuren 1 und zwei im Bereich 11a bis 11d dargestellt sind. Somit kann die Aufteilung der einzelnen Phasen oder der einzelnen Phase auf die Anschlüsse für die jeweiligen Verbraucher bereits im Leitungssegment aufgeteilt werden, wobei jedes Steckersegment eines Leitungssegments dieses mit einem Verbraucher verbinden kann. Ein Steckersegment ist schematisch in den Figuren 1 und 2 durch jeweils ein paar von Leitungen der Gruppe 11 (Stecker 11) dargestellt. Durch entsprechend variable Zuordnung von Steckersegmentpositionen in dem Stecker 11 zu einer Phase, einem Null-Leiter oder einer Potentiellen Erde kann in einfacherweise ein Verbraucher mit beispielsweise einer oder zwei Phasen der Gebäudeenergieversorgung verbunden werden.

An einer vorderen Seite des Verteilers 12 kann mindestens ein Schalter vorgesehen sein, mittels welchem die Stromzufuhr von der Gebäudeenergieversorgung zu einem Verbraucher unterbrechbar beziehungsweise herstellbar ist. Nach dem Ausführungsbeispiel gemäß Fig. 3 sind 12 solche Schalter vorgesehen, wobei jedes der Schalter einen Anschluss für einen Verbraucher oder eine Gruppe von Anschlüssen für Verbraucher von der Gebäudeenergieversorgung trennen beziehungsweise mit dieser verbinden kann.

Auf der Rückseite des Verteilers 12 ist ein weiterer Anschluss vorgesehen, in welchem ein weiterer Stecker 13 angeordnet ist. Dieser verbindet über entsprechende Leitungen die einzelnen Verbraucheranschlüsse lösbar mit dem Verbinder 12. Grundsätzlich kann es sich bei dem Verbinder als Element zwischen dem Stecker 11 und dem Stecker 13 lediglich um eine Weiterleitung der Energie, ohne Veränderung der inneren Verkabelung, handeln. Erfindungsgemäß ist jeweils eine Sicherung für jede Leitung vorgesehen. Besonders bevorzugt weist jede der Leitungen eine separate Sicherung auf.

Die Steckverbindung zwischen dem Verbinder 12 und dem Stecker 13 kann sich von der Steckverbindung zwischen dem Verbinder 12 und dem Stecker 11, insbesondere geometrisch, unterscheiden. Hierdurch kann einem falschen Verbinden der einzelnen Stecker 11, 13 mit dem Verbinder 12 vorgebeugt sein.

Am anderen Ende der mit dem Stecker 13 verbundenen Leitungen kann eine Aufnahme 14 vorgesehen sein, wie sie beispielsweise aus Fig. 5 hervorgeht. Diese ist gemäß dem in Fig. 5 dargestellten Ausführungsbeispiel an einer Steckerleiste 15 angeordnet, welche eine Mehrzahl an Verbraucheranschlüssen aufweist. Jeweils eine Gruppe von drei Verbraucheranschlüssen ist beispielhaft mit den Ziffern 16, 17 und 18 bezeichnet. Jede Gruppe von Verbraucheranschlüssen kann eine beliebige Anzahl an Verbraucheranschlüssen aufweisen. Dies umfasst ebenfalls einen einzelnen Verbraucheranschluss pro Gruppe. Grundsätzlich kann eine beliebige Anzahl an Verbraucheranschlussgruppen an der Steckerleiste 15 vorgesehen sein. Über die einzelnen Verbraucheranschlüsse können Verbraucher mit der Steckerleiste des erfindungsgemäßen Stromanschlussverteilers verbunden werden.

Fig. 6 zeigt einen vergrößerten Ausschnitt einer erfindungsgemäßen Steckerleiste 15. In dieser sind jeweils 2 Gruppen 16 und 17 von 3 Verbraucheranschlüssen dargestellt, welche über einen entsprechenden Schalter, wie er in Fig. 3 auf der Vorderseite des Verteilers 12 angeordnet sind, mit der Gebäudeenergieversorgung stromleitend verbindbar beziehungsweise trennbar sind, ohne dass hierfür eine Leitung beziehungsweise ein Kabel gelöst oder verbunden werden muss.

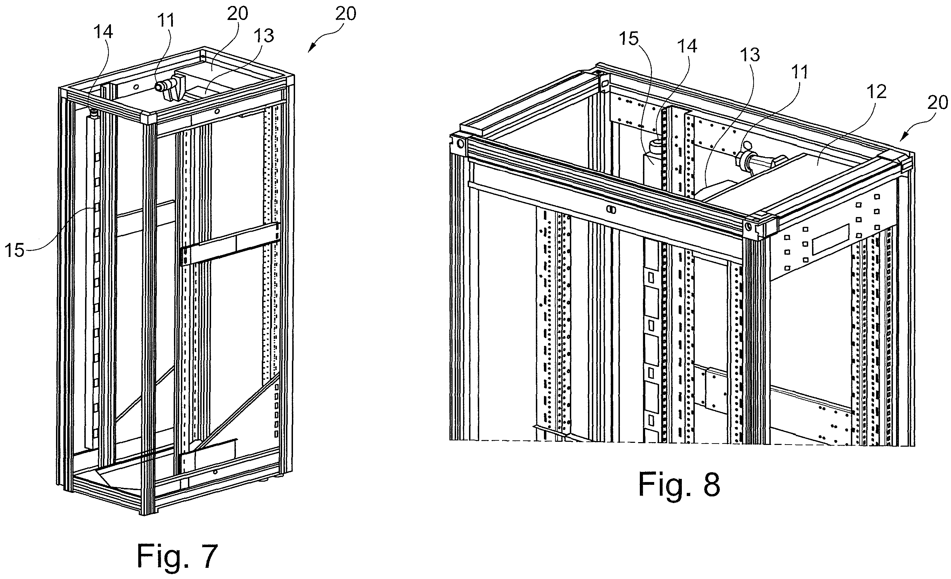

Fig. 7 zeigt eine perspektivische Darstellung eines erfindungsgemäßen Serverschranks 20, welcher mit dem erfindungsgemäßen Stromanschlussverteiler ausgebildet ist. Der Verbinder 12 ist in einem sogenannten 19 Zoll Bereich des Serverschrankes 20 vorgesehen. In diesem Bereich können die einzelnen Servermodule, welche in einem Serverschrank Verbraucher sein können, angeordnet werden. Außerhalb des 19 Zollbereichs, seitlich vertikal angeordnet, ist die Steckerleiste 15 vorgesehen, welche Verbraucheranschlüsse für die einzelnen Verbraucher in dem Serverschrank aufweist. Grundsätzlich kann der Verteiler 12 auch außerhalb des 19 Zoll Bereichs vorgesehen sein, wodurch zusätzlicher Platz für Servermodule bereitgestellt ist.

Fig. 8 zeigt eine vergrößerte Darstellung einer perspektivischen Ansicht auf einen Bereich des Serverschranks 20 mit dem im 19 Zoll Bereich angeordneten Verteiler 12 sowie der außerhalb des 19 Zoll Bereichs angeordneten Steckerleiste 15. Aus Gründen der Übersichtlichkeit ist sowohl in Fig. 7 als auch in Fig. 8 der Stromanschlussverteiler ohne Kabelanteile zwischen Gebäudeenergieversorgung und Verteiler 12 beziehungsweise zwischen Verteiler 12 und der Steckerleiste 15 dargestellt. Die einzelnen Stecker 11 und 13 beziehungsweise die Aufnahme 14, wie sie bereits voranstehend beschrieben wurden, sind in den Figuren 7 und 8 ebenfalls dargestellt. Die energieleitende Verbindung zwischen Gebäudeenergieversorgung, Verteiler 12 und Steckerleiste 15 kann gemäß den Figuren 7 und 8 in der gleichen Weise bereitgestellt werden, wie sie bereits voranstehend hinsichtlich der Stecker 11 und 13 beziehungsweise hinsichtlich der Aufnahme 14 ausgeführt wurden.

## Patentansprüche

1. Stromanschlussverteiler für elektrische Energie mit
mindestens einem Verbraucheranschluss (16) für mindestens einen Verbraucher, zum Versorgen des Verbrauchers mit elektrischer Energie,
mindestens einem Verbindungselement zu einer Gebäudeenergieversorgung, insbesondere zu mindestens einem Starkstromanschluss, welches den mindestens einen Verbraucher mit der Gebäudeenergieversorgung verbindet, mindestens einem Leitungselement (10a, b, d), welches zwischen dem Verbindungselement und dem mindestens einen Verbraucheranschluss (16) vorgesehen ist,
einem Verbinder (12), welcher zwischen Verbraucheranschluss (16) und Verbindungselement angeordnet ist, wobei das Verbindungselement verbraucherseitig mindestens zwei Leiter (L1, L2) zur Energieversorgung aufweist, die mit dem mindestens einen Verbraucher stromleitend in Verbindung stehen,
wobei der Verbinder (12) energieversorgungsseitig mit dem mindestens einem Leitungselement (10a, b, d) in Verbindung steht,
welches jeweils mit mindestens zwei Leitern (L1, L2) zur Energieversorgung ausgebildet ist, die an die Gebäudeenergieversorgung anschließbar sind,
wobei in Abhängigkeit von der Ist-Spannung und/oder dem Stromsystem der Gebäudeenergieversorgung das mit der Gebäudeenergieversorgung zu verbindende Leitungselement (10a, b, d) austauschbar ist, und
wobei zwischen dem Verbinder (12) und jedem der austauschbaren Leitungselemente (10a, b, d) eine standardisierte lösbare Steckverbindung besteht, **dadurch gekennzeichnet ,**
**dass** das Verbindungselement für eine zwei- oder dreiphasige Gebäudeenergieversorgung ausgebildet ist, dass das Leitungselement (10a, b, d) zum Anschluss an 2 oder 3 Phasen ausgelegt ist und
**dass** der Verbinder (12) mit jeweils mindestens einer elektrischen Sicherung für jede Leitung (L1, L2, L3) zur Gebäudeenergieversorgung ausgebildet ist.

2. Stromanschlussverteiler nach Anspruch 1
**dadurch gekennzeichnet,**
**dass** der Verbinder (12) mit mehreren Anschlüssen für Leitungselemente (10a, b, c, d) ausgebildet ist, wobei die zur Verfügung gestellte Energie für den mindestens einen Verbraucher (16) und/oder eine Anzahl an aktiven Verbraucheranschlüssen (16) anpassbar ist.

3. Stromanschlussverteiler nach Anspruch 1 oder 2
**dadurch gekennzeichnet,**
**dass** der Verbinder (12) mit mehreren Verbraucheranschlusssegmenten verbindbar ist, wobei die Energie für den mindestens einen Verbraucher (16) und/oder eine Anzahl an aktiven Verbraucheranschlüssen (16) anpassbar ist.

4. Stromanschlussverteiler nach einem der Ansprüche 1 bis 3
**dadurch gekennzeichnet,**
**dass** über dieselbe Steckverbindung mehr als ein Leitungselement (10a, b, c, d) mit dem Verbinder (12) verbindbar ist.

5. Stromanschlussverteiler nach Anspruch 4
**dadurch gekennzeichnet,**
**dass** die mindestens eine Steckverbindung eine Verdrahtung aufweist, welche zumindest einen ersten Verbraucheranschluss (16) mit Energie versorgt oder eine Verdrahtung aufweist, welche zusätzlich mindestens einen zweiten Verbraucheranschluss (16) mit Energie versorgt.

6. Stromanschlussverteiler nach Anspruch 1 oder 2
**dadurch gekennzeichnet,**
**dass** der Verbinder (12) mit dem Leitungselement (10a, b, c, d) ausgebildet ist.

7. Stromanschlussverteiler nach einem der Ansprüche 1 bis 6,
**dadurch gekennzeichnet,**
**dass** der Verbinder (12) integral mit dem mindestens einen Verbraucheranschluss (16) ausgebildet ist.

8. Serverschrank mit Stromanschlussverteiler nach einem der Ansprüche 1 bis 7.

## Claims

1. Busbar distributor for electrical energy, comprising
at least one consumer terminal (16) for at least one consumer for supplying the consumer with electrical energy,
at least one connecting element for connection to a building energy supply, in particular to at least one high-voltage busbar, which connecting element connects the at least one consumer to the building energy supply,
at least one line element (10a, b, d) which is provided between the connecting element and the at least one consumer terminal (16),
a connector (12) which is arranged between the consumer terminal (16) and the connecting element, wherein the connecting element comprises at least two conductors (L1, L2) for supplying energy on the consumer side, which conductors are connected in an electrically conductive manner to the at least one consumer, wherein the connector (12) is connected, on the energy supply side, to the at least one line element (10a, b, d),
which line element is formed in each case having at least two conductors (L1, L2) for energy supply which can be connected to the building energy supply, wherein the line element (10a, b, d) to be connected to the building energy supply is exchangeable depending on the actual voltage and/or the power system of the building energy supply, and
wherein a standardized detachable plug-in connection is provided between the connector (12) and each of the exchangeable line elements (10a, b, d), **characterized in that**
the connecting element is designed for a two-phase or three-phase building energy supply,
**in that** the line element (10a, b, d) is designed for the connection to two or three phases, and
**in that** the connector (12) is formed having at least one fuse in each case for each line (L1, L2, L3) for building energy supply.

2. Busbar distributor according to claim 1,
**characterized in that**
the connector (12) is formed having a plurality of terminals for line elements (10a, b, c, d), wherein a provided energy is adjustable for the at least one consumer and/or a number of active consumer terminals (16).

3. Busbar distributor according to claim 1 or 2,
**characterized in that**
the connector (12) can be connected to a plurality of consumer terminal segments, wherein energy is adjustable for the at least one consumer (16) and/or a number of active consumer terminals (16).

4. Busbar distributor according to any of claims 1 to 3,
**characterized in that**
more than one line element (10a, b, c, d) can be connected to the connector (12) by means of the same plug connection.

5. Busbar distributor according to claim 4,
**characterized in that**
the at least one plug connection comprises a wiring that supplies energy to at least one first consumer terminal (16), or comprises a wiring that in addition supplies energy to at least one second consumer terminal (16).

6. Busbar distributor according to any of claims 1 to 2,
**characterized in that**
the connector (12) is formed with the line element (10a, b, c, d).

7. Busbar distributor according to any of claims 1 to 6,
**characterized in that**
the connector (12) is formed integrally with the at least one consumer terminal (16).

8. Server cabinet comprising a busbar distributor according to any of claims 1 to 7.

## Revendications

1. Distributeur de branchements électriques pour énergie électrique avec au moins un branchement de charge (16) pour au moins une charge, pour alimenter la charge en énergie électrique,
au moins un élément de connexion à une alimentation en énergie de bâtiment, en particulier à au moins un branchement de courant fort qui relie l'au moins une charge avec l'alimentation en énergie de bâtiment,
au moins un élément conducteur (10a, b, d) qui est prévu entre l'élément de connexion et l'au moins un branchement de charge (16),
un connecteur (12) qui est disposé entre le branchement de charge (16) et l'élément de connexion, l'élément de connexion présentant du côté charge au moins deux conducteurs (L1, L2) vers l'alimentation en énergie, qui sont en liaison électrique avec l'au moins une charge,
le connecteur (12) étant en liaison du côté de l'alimentation en énergie avec l'au moins un élément conducteur (10a, b, d),
qui est constitué avec au moins deux conducteurs (L1, L2) vers l'alimentation en énergie qui peuvent être branchés à l'alimentation en énergie de bâtiment,
l'élément conducteur (10a, b, d) à raccorder avec l'alimentation en énergie de bâtiment pouvant être remplacé en fonction de la tension réelle et/ou du système électrique de l'alimentation en énergie de bâtiment, et
une connexion enfichable amovible standardisée se trouvant entre le connecteur (12) et chacun des éléments conducteurs remplaçables (10a, b, d),
**caractérisé en ce que**
l'élément de connexion est formé pour une alimentation en énergie de bâtiment biphasée ou triphasée,
que l'élément conducteur (10a, b, d) est conçu pour le branchement à 2 ou 3 phases et
que le connecteur (12) est formé avec au moins un coupe-circuit électrique pour chaque conducteur (L1, L2, L3) vers l'alimentation en énergie de bâtiment.

2. Distributeur de branchements électriques selon la revendication 1
**caractérisé en ce que**
le connecteur (12) est formé avec plusieurs branchements pour les éléments conducteurs (10a, b, c, d), l'énergie mise à disposition pouvant être adaptée pour l'au moins une charge (16) et/ou un certain nombre de branchements de charge (16) actifs.

3. Distributeur de branchements électriques selon la revendication 1 ou 2
**caractérisé en ce que**
le connecteur (12) peut être raccordé avec plusieurs segments de branchement de charge, l'énergie pouvant être adaptée pour l'au moins une charge (16) et/ou un certain nombre de branchements de charge (16) actifs.

4. Distributeur de branchements électriques selon une des revendications 1 à 3
**caractérisé en ce que**
plus d'un élément conducteur (10a, b, c, d) peut être raccordé avec le connecteur (12) par la même connexion enfichable.

5. Distributeur de branchements électriques selon la revendication 4
**caractérisé en ce que**
l'au moins une connexion enfichable présente un câblage qui alimente au moins un premier branchement de charge (16) en énergie ou présente un câblage qui alimente en outre au moins un deuxième branchement de charge (16) en énergie.

6. Distributeur de branchements électriques selon la revendication 1 ou 2
**caractérisé en ce que**
le connecteur (12) est formé avec l'élément conducteur (10a, b, c, d).

7. Distributeur de branchements électriques selon une des revendications 1 à 6,
**caractérisé en ce que**
le connecteur (12) est formé de manière solidaire avec au moins un branchement de charge (16).

8. Armoire de serveur avec un distributeur de branchements électriques selon une des revendications 1 à 7.
